(19) Europäisches Patentamt

European Patent Office

Office européen des brevets

(11) **EP 0 655 151 B1**

(12) **EUROPEAN PATENT SPECIFICATION**

(45) Date of publication and mention
of the grant of the patent:
**22.03.2000 Bulletin 2000/12**

(51) Int. Cl.$^7$: **G06F 17/00**, H03H 21/00

(21) Application number: **92920567.2**

(86) International application number:
**PCT/US92/07650**

(22) Date of filing: **15.09.1992**

(87) International publication number:
**WO 94/04980 (03.03.1994 Gazette 1994/06)**

(54) **MULTIPLE INTERACTING DVE ALGORITHM**

DIGITALER VIRTUELLER ERDE-ALGORITHMUS UNTER VERWENDUNG VON MEHRFACHEN
INTERAKTIONEN

ALGORITHME DE TERRE VIRTUELLE NUMERIQUE A INTERACTIONS MULTIPLES

(84) Designated Contracting States:
**AT BE CH DE DK ES FR GB GR IE IT LI LU MC NL
SE**

(30) Priority: **12.08.1992 US 928471**

(43) Date of publication of application:
**31.05.1995 Bulletin 1995/22**

(73) Proprietor:
**NOISE CANCELLATION TECHNOLOGIES, INC.
Linthicum, MD 21090 (US)**

(72) Inventor: **ZIEGLER, Eldon, Jr.
Columbia, MD 21046 (US)**

(74) Representative:
**Wilhelm & Dauster
Patentanwälte
European Patent Attorneys
Hospitalstrasse 8
70174 Stuttgart (DE)**

(56) References cited:
**US-A- 4 715 559        US-A- 5 068 813
US-A- 5 105 377**

• **IEEE TRANSACTIONS ON ACOUSTICS,SPEECH
AND SIGNAL PROCESSING, vol. 35, no. 10,
October 1987 pages 1423-1434, XP 000014939
ELLIOTT S J ET AL 'A MULTIPLE ERROR LMS
ALGORITHM AND ITS APPLICATION TO THE
ACTIVE CONTROL OF SOUND AND VIBRATION'**

## Description

Present application relates to an active cancellation system comprising multiple sensor means for detecting vibration phenomena, each sensor means producing an appropriate residual signal, a processor means, input circuitry means coupled to the multiple sensor means and adapted to convert said residual signals into a digital form adapted to be used by said processor means, output circuitry means, adapted to convert multiple digital output signals from said processor means into analog form, multiple output actuators for producing counter vibration phenomena, whereby said processor means is coupled to said input and said output circuitry means to receive the multiple residual input signals and produce the multiple output signals based upon a combination of said residual signals, whereupon said vibration phenomena are cancelled. Such active cancellation system is adapted to cancel repetitive or non-repetitive phenomena. It makes use of the extension of the digital virtual earth technology to applications involving multiple interacting sensors and actuators.

The application further relates to a method to cancel noise comprising the steps of detecting multiple residual noise phenomena, converting said multiple residual noise phenomena into digital form, feeding said digitized residual noise phenomena into a processor, calculating multiple output signals in said processor and outputting said multiple output signals to generate counter vibration phenomena.

In US 5 091 953 (Tretter) an active cancellation system is disclosed comprising multiple actuator and sensor means connected to a processor means. Said processor means includes a microprocessor which is programmed to execute algorithms based on variable input signals stemming from the sensor means. At known fundamental frequencies phase an amplitude of a cancelling signal are calculated for controlling the respective actuators.

The article "A Multiple Error LMS Algorithm and its Application to the Active Control of Sound and Vibration", IEEE Transactions on Acoustics, Speech and Signal Processing, Volume ASSP-35, No. 10, October 1987, page 1423 by Stephen J. Elliott et al. discloses an active cancellation system comprising multiple actuator and sensor means and a processor means. Noise is cancelled by passing a single reference signal derived from the noise source through FIR-filters (fast impulse response filters) the taps of which are adjusted by a modified version of the LMS algorithm.

In U.S. Patent Number 5,105,377 by the same inventor there is described an active cancellation system for repetitive or non-repetitive phenomena which estimates the noise signal by subtracting the predicted effects of the cancellation signal from the residual sensor signal. In this single input, single output system, an LMS filtered-x algorithm is employed to adapt the cancellation filter coefficients. The adaptive filter produces the cancellation signal by filtering the estimated noise with filter weights that are adapted using the residual signal and the estimated noise convolved with the system impulse response. The single channel version of the DVE algorithm is described by the equations:

$$x_k = e_k - \sum_l C_l \cdot y_{k-l}$$

$$y_k = \sum_m A_{m,k} \cdot x_{k-m}$$

$$A_{m,k+l} = A_{m,k} - \alpha \cdot e_k \cdot \sum_l C_l \cdot x_{k-l}$$

where:

$y_k$    is the cancellation signal value at sample k,
$e_k$    is the error signal value at sample k,
C    is the vector of coefficients of the impulse response from the controller output to the error sensor input,
A    is the vector of coefficients of the cancellation filter,
$x_k$    is the value of the estimated noise signal at sample k and
$\alpha$    is the LMS convergence rate coefficient.

This form of the algorithm is only applicable to systems consisting of one channel, i.e. a single sensor and a single actuator. In many situations, a multiple channel version of the algorithm is necessary to provide complete cancellation. Therefore, there exists a need for a digital virtual earth active cancellation system which is applicable to multiple input-output channels.

NFA    is the number of elements in the vector A,
$A_{m,k}$    is the m'th element of the vector A at sample k,
$y_k$    is the cancellation signal value at sample k,
$e_k$    is the error signal value at sample k,
C    is the vector of coefficients of the impulse response from the controller output to the error sensor input,
A    is the vector of coefficients of the cancellation filter,
$x_k$    is the value of the estimated noise signal at sample k and
$\alpha$    is the LMS convergence rate coefficient.

This form of the algorithm is only applicable to systems consisting of one channel, i.e. a single sensor and a single actuator. In many situations, a multiple channel version of the algorithm is necessary to provide complete cancellation. Therefore, there exists a need for a digital virtual earth active cancellation system which is applicable to multiple input-output channels.

## SUMMARY OF THE INVENTION

The multiple interacting DVE (MIDVE) algorithm computes an estimate of the noise at each sensor by subtracting out the combined effects of each actuator signal according to the following equations:

$$x_{s,k} = e_{s,k} - \sum_{a=0}^{NA-1} \sum_{l=0}^{NC_{a,s}-1} C_{a,s,l} \, y_{a,k-l}$$

$NA$         is the number of actuators,

$NS$         is the number of sensors,

$C_{a,s}$        is the vector of coefficients of the impulse response (from the controller output to the error sensor input) from actuator a to sensor s,

$NC_{a,s}$       is the number of elements of the vector $C_{a,s}$

$C_{a,s,l}$       is the $l$'th element of the vector $C_{a,s}$

$Y_{a,k-l}$       is the cancellation signal value for actuator a at sample $k-l$ and

$e_{s,k}$        is the error signal value from sensor s at sample k.

$g_{a,s,k}$       is the result at sample k of convolving the values of the estimated noise signal with the vector $C_{a,s}$.

$G_{a,s,m,k}$      is the m'th element of the vector of the most recent values of $g_{a,s}$ at sample k

where the subscripts a and s indicate the actuator and sensor. The remaining variables are as described above but extended to different sensors and actuators, (and pairs of sensors and actuators as with the impulse responses and cancellation coefficients).

The cancellation signal for each actuator is computed by summing the partial cancellation signals based on the estimated noise signal at each sensor as follows:

$$y_{a,k} = - \sum_{s=0}^{NS-1} \sum_{m=0}^{NFA_{a,s}-1} A_{s,a,m,k} \, x_{s,k-m}$$

where:

$A_{s,a,*,k}$      is the vector of coefficients of the cancellation filter between sensor s and actuator a at sample k

$NFA_{s,a}$      is the number of elements in $A_{s,a}$

$A_{s,a,m,k}$      is the m'th element of the vector A for sensor s and actuator a at sample k.

The cancellation filter coefficients are updated using a multidimensional filtered-x algorithm as follows:

$$g_{a,s,k} = \sum_{l=0}^{NC-1} C_{a,s,l} \, x_{s,k-l}$$

$$A_{s,a,m,k+l} = A_{s,a,m,k} + \alpha \, e_{s,k} \, G_{a,s,m,k}$$

This extension of the single input, single output DVE algorithm to multichannel applications follows, in only the most general terms, the methodology described in an article entitled An Adaptive Algorithm for Active Cancellation of a Wideband Random Field by S.N. Arzamasov and A.A. Mal'tov. This paper was submitted April 11, 1984 to Gor'ku University, and published in Izvestiya Vysshikh Uchebnykh Zavedenii, Radiofizika, Vol. 28, No. 8, pp. 1008-1016, in August 1985 (and translated to English by Plenum Publishing Corporation). However, the Arzamasov/Mal'tov approach requires 2 levels of input sensors (an "upstream" sensor and a "downstream" sensor) for each cancellation output transducer. The present invention eliminates the need for such a requirement. In a MIDVE system, only 1 sensor is needed for each output channel. This reduces not only cost over the prior art but also reduces the computational burden on the system processor.

## BRIEF DESCRIPTION OF THE DRAWINGS

Figure 1 is a block diagram showing the basic MIDVE system.

Figure 2 is a block diagram detailing the impulse responses between the multiple interacting inputs and outputs.

Figure 3A is a more detailed block diagram of an embodiment of one channel of the input section of the MIDVE system of Figure 1 constructed in accordance with the present invention used in the system of Figure 1.

Figure 3B is an alternate embodiment of the input channel detailed in Figure 3A.

Figure 4A is a more detailed block diagram of an embodiment of one channel of the output section of the MIDVE system of Figure 1 constructed in accordance with the present invention used in the system of Figure 1.

Figure 4B is an alternate embodiment of the output channel detailed in Figure 4A.

Figure 5 is a depiction of how Figures 5A and 5B are joined to form a single block diagram.

Figures 5A and 5B are block diagrams showing the partial operation of an embodiment of the processor constructed in accordance with the present invention used in the system of Figure 1.

DETAILED DESCRIPTION

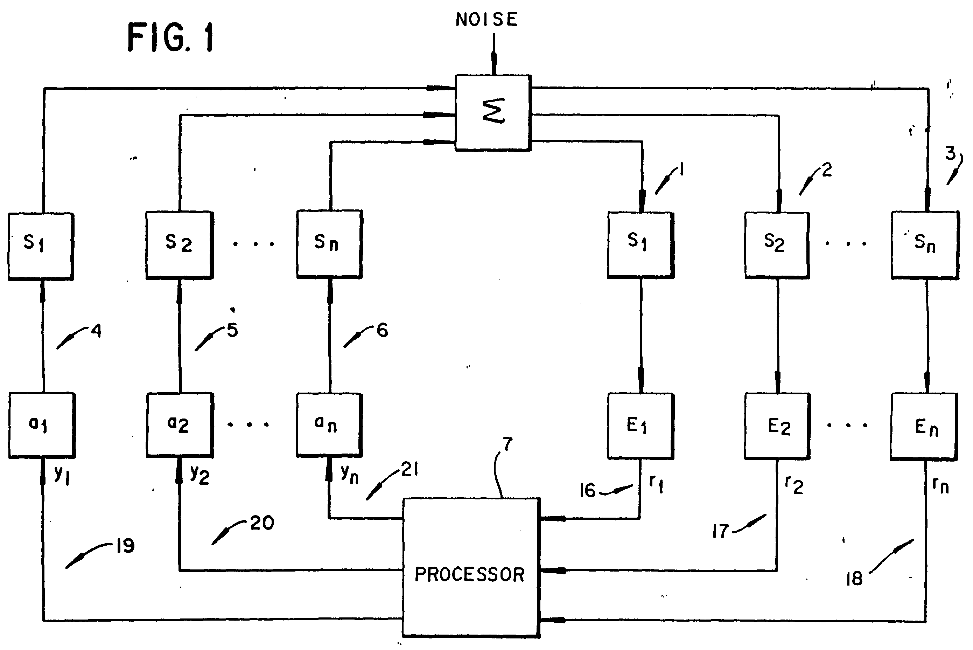

Figure 1 is a block diagram which depicts the basic composition of a MIDVE system. For the remainder of the context of this discussion, only 3 channels of the MIDVE system will be diagrammed. The last, channel "n", should be understood to represent the $n^{th}$ channel of an n-channel system. So, the system is made up of residual sensors 1, 2, and 3, actuators 4, 5, and 6, and a processor 7. The system functions as follows. Phenomena (e.g. noise and/or vibration) are received by the multiple residual sensors 1, 2 and 3. In response, these sensors emit their respective sensor signals. These sensor signals are affected by various system factors which have impulse responses $E_1$, $E_2$,......, and $E_n$. The resulting residual signals $r_1$, $r_2$,......, and $r_n$ (16, 17, and 18) are received by the processor 7 which it uses to generate the cancellation signals $y_1$, $y_2$,... , and $y_n$ (19, 20, and 21). These cancellation signals are affected by various factors which have impulse responses $S_1$, $S_2$,......, and $S_n$ The resulting cancellation output phenomena from the actuators 4, 5, and 6 combines with the original phenomena, and the residual is detected by the residual sensors 1, 2, and 3.

The signal values are determined by

$$y_{a,k} = - \sum_{s=0}^{NS-1} \sum_{m=0}^{NFA_{a,s}-1} A_{s,a,m,k}\, x_{s,k-m}$$

where

$y_{a,k}$     is the cancellation signal from actuator a at time k

$x_{s,k-m}$     is the value of the estimated noise signal at sensor s at time k-m and

$A_{s,a,m,k}$     is the $m^{th}$ coefficient at time k of the cancellation filter associated with sensor s and actuator a.

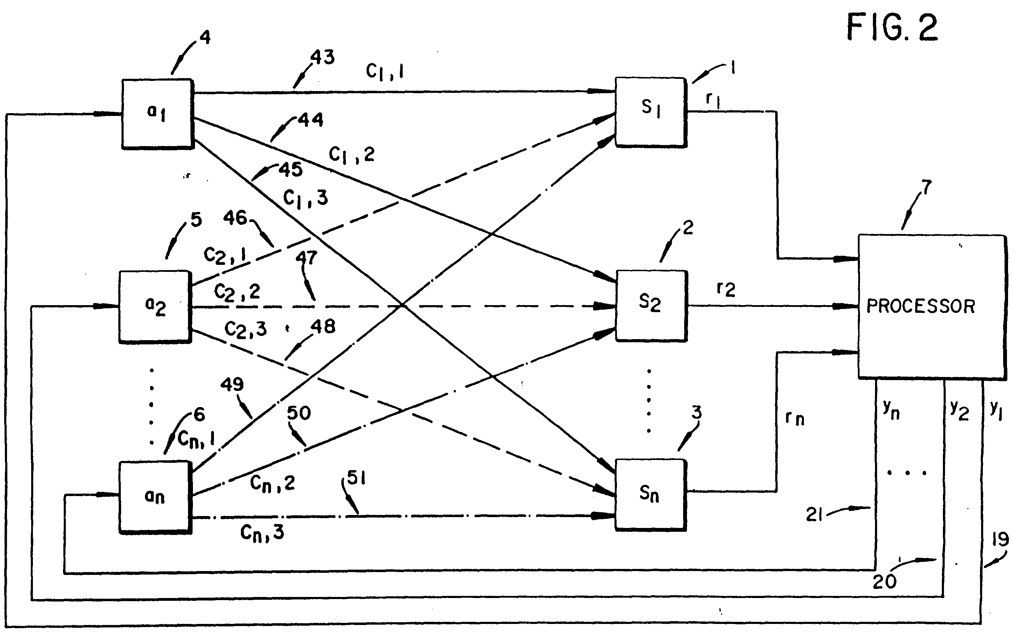

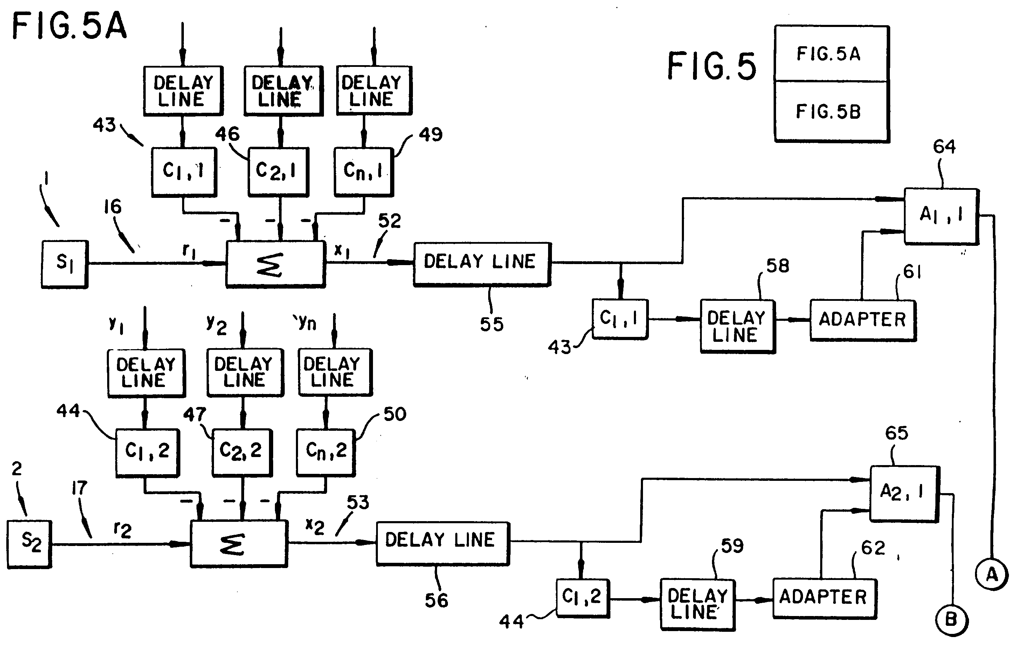

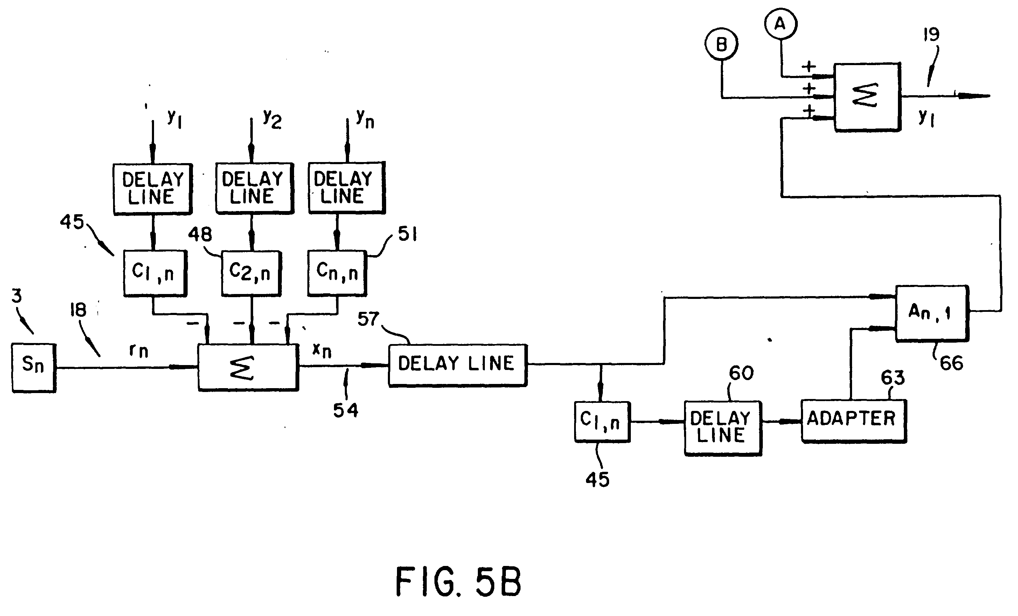

Figure 2 is a block diagram showing all of the paths of the impulse responses between the multiple inputs and outputs of the system. At each sensor, the output of each actuator has been affected by the impulse response between that sensor and the respective actuator. The designations $C_{1,1}$ through $C_{n,3}$ denote the vectors of coefficients of the impulse responses (from the controller output to the error sensor input) from actuator $a_1$ to sensor $S_1$ and so on through actuator $a_n$ to sensor $S_n$. The term $C_{a,s}$ is a general term, the specific terms $C_{1,1}$, etc., are enumerated instead of general. Each one is an instance of the variables of the general term $C_{a,s}$. The C's shown in Figure 5 are estimates of physical actual values shown in Figure 2, this is obvious from the text. In Figure 2 the C's are actual values and in Figure 5 they are estimates as are all of the equations estimates.

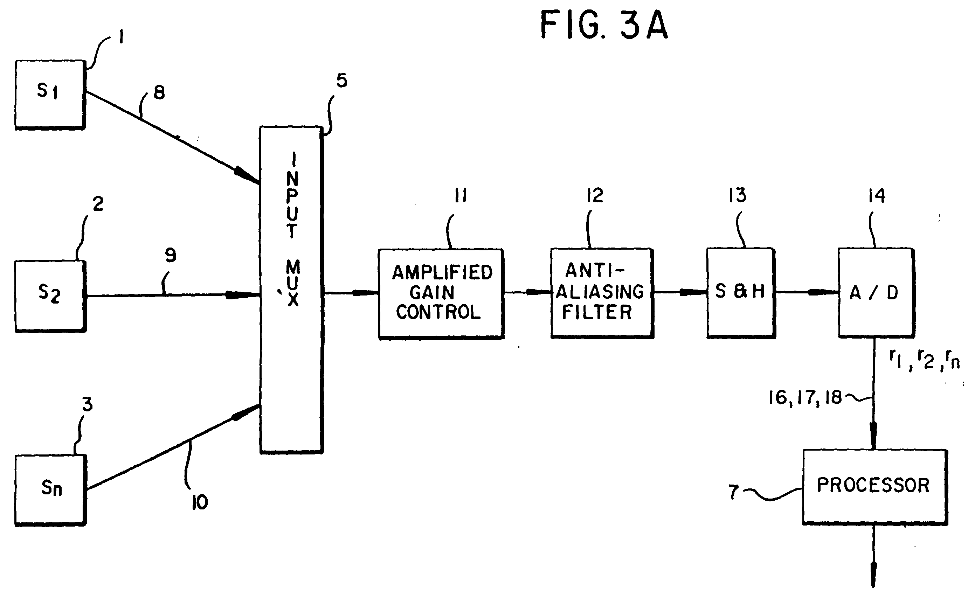

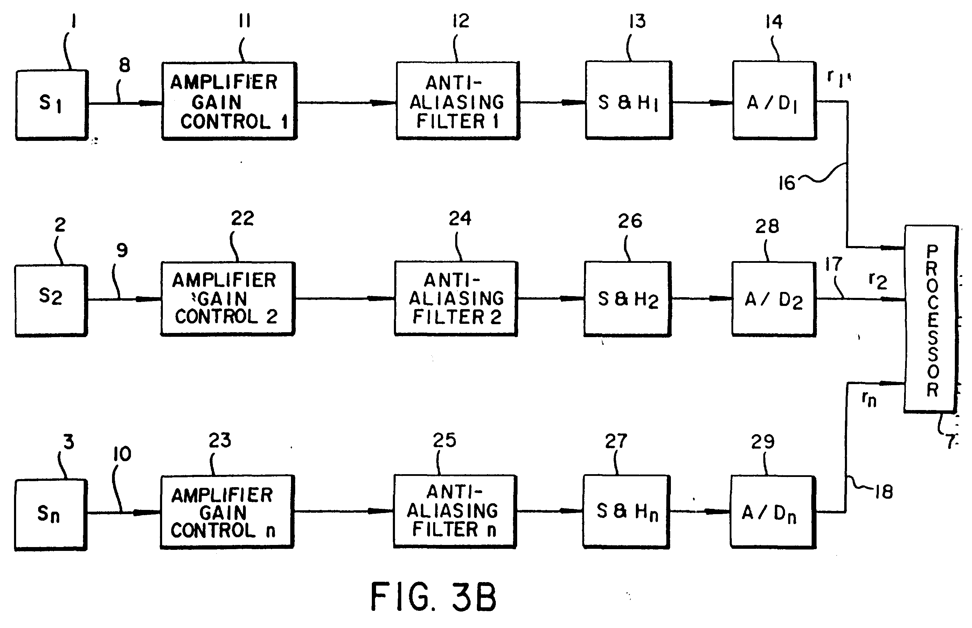

Figures 3A and 3B are more detailed block diagrams of the input section of the MIDVE system. The residual sensors 1, 2, and 3 detect the noise and/or vibration phenomena and in response emit sensor signals 8, 9, and 10. Each of these signals pass through an amplifier/gain stage 11, and are then conditioned by anti-aliasing circuitry 12 These conditioned signals are then sampled and converted to digital signals through the combination of the sample-and-hold circuitry 13 and the analog-to-digital converter (A/D), 14. Note that, although described pictorially as a separate entity, the sample-and -hold circuitry could be part of 14. In addition, note that the multiple input signals could be multiplexed 15 through one set of input conditioning circuitry (Figure 3A) or each could have its own set of dedicated input circuitry (Figure 3B). In Figure 3B, the additional circuitry required would consist of additional amplifier/gain control stages 22 and 23, additional anti-aliasing filters 24 and 25, additional sample-and-hold circuitry 26 and 27, and additional A/D's 28 and 29. The resulting digital input values, the residual signals $r_1$, $r_2$, and $r_n$ (16, 17, and 18), are then available for use by the processor 7. The processor consumes the input data values and from them produces the appropriate cancellation output signal. Other embodiments of the input electronic circuitry could be used in place of that described above and shown in Figure 3B in order to provide the input data.

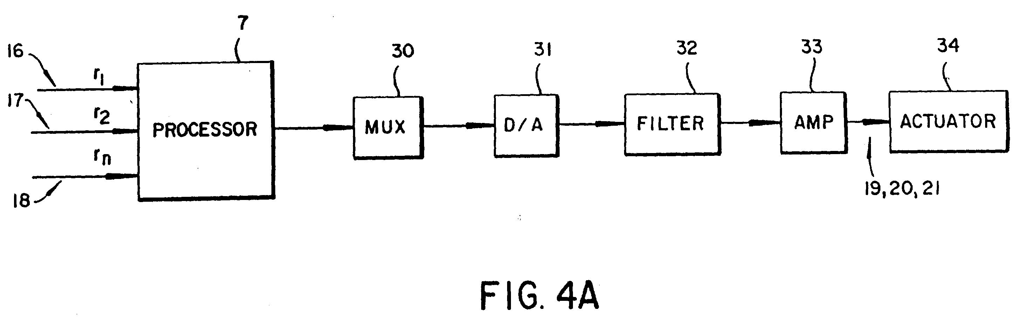

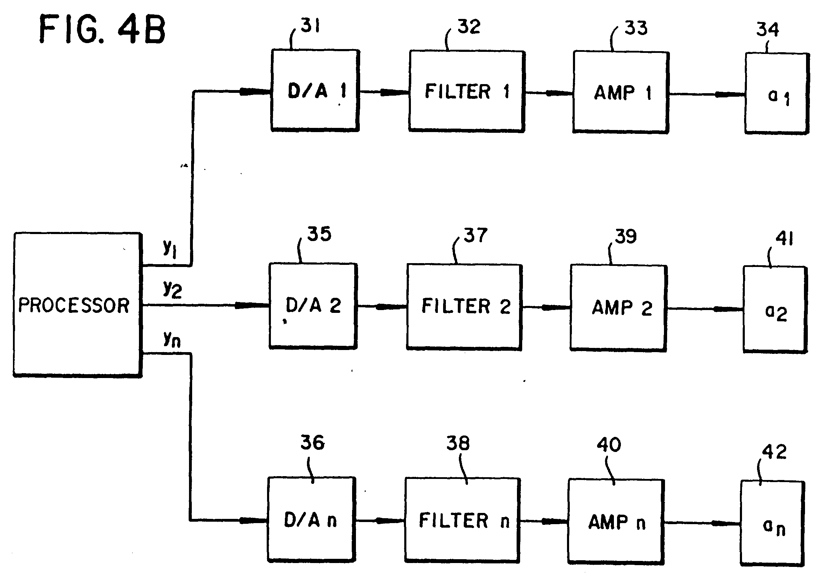

Figures 4A and 4B are more detailed diagrams of the output section of the MIDVE system. The residual signals $r_1$, $r_2$ and $r_n$ (16, 17, and 18) from the input section are used by the processor, along with the system impulse response, to produce the appropriate cancellation signals $y_1$, $y_2$, and $y_n$ (19, 20, and 21). The cancellation signals are converted to analog form by the digital-to-analog converter 31. These analog signals then pass through a reconstruction filter 32, are amplified by a gain stage 33, and are then converted to physical phenomena by actuator 34. The resulting cancellation phenomena mixes with the original noise/vibration phenomena and the residual is detected by residual sensors 1, 2, and 3 in the input section of the system. Note that the multiple output signals could be multiplexed, as at 30, through one set of output circuitry (Figure 4A) or each could have its own set of dedicated input circuitry (Figure 4B). In Figure 4B, the additional circuitry required would consist of additional D/A's 35 and 36, additional reconstruction filters 37 and 38, additional amplifier/gain stages 39 and 40, and additional actuators 41 and 42. In the MIDVE system, the system impulse response for any given output section includes the impulse response S of the respective output circuitry 31, 32, 33, 34, and another configuration, if desired, and the impulse responses $E_1$, $E_2$,......, and $E_n$ of the input circuitry 11, 12, 13, 14, (if so configured) of each of the multiple input sections. Thus, each input channel of the system has an effect on the output of each channel.

Figure 5, comprising Figures 5A and 5B, is a block diagram showing the partial operation of an embodiment of the processor 7 constructed in accordance with the present invention used in the system of Figure 1. The processor 7 receives the residual signals $r_1$, $r_2$, and $r_n$ (16, 17, and 18) from the multiple sensors. The MIDVE algorithm estimates the noise at each sensor by subtracting out the combined effects of each actuator signal from the residual signal as follows:

$$x_{s,k} = e_{s,k} - \sum_{a=0}^{NA-1} \sum_{l=0}^{NC_{a,s}-1} C_{a,s,l}\, y_{a,k-l}$$

where the subscripts a and s denote the actuator and sensor, and the subscript k denotes the value at sample time k. The estimates $x_1$, $x_2$, and $x_n$ (52, 53, and 54) of the noise at each sensor proceed from their respective summation points, through delay lines 55, 56, and 57, and each are input to adaptive filters 64, 65, and 66. The output of the adaptive filters, each having filter weights $A_{m,n}$, are summed, then inverted, and the resulting signal is output to the output circuitry. Thus, the processor computes the cancellation signal for each actuator as follows:

$$y_{a,k} = \sum_{s=0}^{NS-1} \sum_{m=0}^{NFA_{a,s}-1} A_{s,a,m,k}\, x_{s,k-m}$$

The output delay lines 55, 56, and 57 are also provided to a second set of filters 143, 144, and 145 that are a model of the impulse response between the respective sensor and actuator. The output from these filters proceed through another set of delay lines 58, 59, and 60, and are then used by adapters 61, 62, and 63. These adapters use the filtered outputs, along with the original residual signals $r_1$, $r_2$, and $r_n$, to provide adaptation signals to the adaptive filters 64, 65, and 66. These adaptation signals are used to adjust the adaptive filter weights $A_{m,n}$. The cancellation filter coefficients are updated using a multidimensional filtered-x algorithm as follows:

$$g_{a,s,k} = \sum_{l=0}^{NC-1} C_{a,s,l}\, x_{s,k-l}$$

$$A_{s,a,m,k+l} = A_{s,a,m,k} + \alpha\, e_{s,k}\, G_{a,s,m,k}$$

The diagram of Figures 5A and 5B show the operations that the processor performs in calculating the output for channel 1 of the MIDVE system, but would be similarly extended for all other output channels.

The processor 7 depicted in Figures 5A and 5B could be implemented in any of several forms including fixed program hardware, custom VLSI, or in one or more stored program microprocessors.

## Claims

1. Active cancellation system comprising:

   - multiple sensor means (1,2,3) for detecting vibration phenomena, each sensor means producing an appropriate residual signal $e_s(t)$,
   - a processor means (7),
   - input circuitry means (11, 12, 13, 14; 22, 24, 26, 28; 23, 25, 27, 29) coupled to the multiple sensor means (1,2,3) and adapted to convert said residual signals into a digital form adapted to be used by said processor means (7),
   - output circuitry means (31, 32, 33; 35, 37, 39; 36, 38, 40) adapted to convert multiple digital output signals $y_a(t)$ from said processor means (7) into analog form,
   - multiple output actuators (34,41,42) for procuding counter vibration phenomena,

   whereby said processor means (7) is coupled to said input and said output circuitry means to receive the multiple residual input signals $e_s(t)$ and produce the multiple output signals $y_a(t)$ based upon a combination of said residual signals, whereupon said vibration phenomena are canceled, **characterized in that** said processor means (7) contains a program based on an algorithm in which the combined effects of each of the actuator signals $y_a(t)$ on each of the residual signals $e_s(t)$ are subtracted out to provide estimated sensor signals $x_s(t)$ of sensors without counter signals and in which estimated sensor signals $x_s(t)$ are convolved with adaptive cancellation filter coefficients $A_{s,a,m}(t)$ to form said multiple output signals $y_a(t)$ with the adaptive filter coefficients being updated based on the residual signals and the estimated sensor signals.

2. A system as in claim 1, wherein said input circuitry means includes sample-and-hold circuit means (13,26,27) and an analog to digital converter means (14,28,29).

3. A system as in claim 1 or 2, wherein input circuitry means comprises a multiplicity of dedicated input circuitry means, one for each input signal.

4. A system as in claim 3, wherein each dedicated input circuitry means includes amplifier/gain control stages (11,22,23), anti-aliasing filters (12,24,25), sample-and-hold circuitry (13,26,27) and analog to digital converters (14,28,29).

5. A system as in claim 1 to 4 wherein said processor means (7) includes means to employ a multi-dimensional filtered-x-algorithm to update the cancellation filter coefficients to subtract out the combined effects of each of the actuator signals from the residual signals to provide an estimated input signal at each sensor means.

**6.** A system as in claim 1 to 5, wherein said processor means (7) further includes means to convolve said estimated input signals $x_s(t)$ with cancellation filter coefficients $A_{s,a,m}(t)$ to produce output signals.

**7.** A system as in claim 1 to 6, wherein said processor means (7) further includes means to continually update the cancellation filter coefficients $A_{s,a,m}(t)$.

**8.** A system as in one of the preceding claims, wherein said processor means (7) includes means to update cancellation filter coefficients $A_{s,a,m}(t)$ to provide estimated input signals $x_s(t)$ at each sensor and to convolve said signals with said coefficients to produce output signals.

**9.** A method to cancel noise comprising the steps of

- detecting multiple residual noise phenomena $e_s(t)$,
- converting said multiple residual noise phenomena into digital form,
- feeding said digitized residual noise phenomena into a processor,
- calculating multiple output signals in said processor,
- outputting said multiple output signals to generate counter vibration phenomena

**characterized in that**
it further comprises the steps of

- subtracting out the combined effects of each of the actuator signals $y_a(t)$ on each of the residual signals $e_s(t)$ to provide estimated sensor signals $x_s(t)$,
- convolving said estimated sensor signals $x_s(t)$ with adaptive cancellation filter coefficients $A_{s,a,m}(t)$ to form said multiple output signals $y_a(t)$,
  whereby the adaptive cancellation filter coefficients are continually updated based on the residual signals and the estimated sensor signals by employing a multi-dimensional filtered-x algorithm.

**10.** A method as in claim 9,
wherein the multiple output signals and the estimated sensor signals $x_s(t)$ are passed through filters that are a model of the impulse response between the respective sensors and actuators.

**Patentansprüche**

**1.** Aktives Auslöschungs-System mit:

- mehreren Sensor-Mitteln (1,2,3), um Vibrationserscheinungen zu detektieren, wobei ein jedes Sensor-Mittel ein geeignetes Rest-Signal $e_s(t)$ erzeugt,
- einem Prozessor-Mittel (7),
- Eingangssignal-Schaltkreis-Mitteln (11, 12, 13, 14; 22, 24, 26, 28; 23, 25, 27, 29), die mit den mehreren Sensor-Mitteln (1,2,3) gekoppelt sind und dazu dienen, die Rest-Signale in eine digitale Form zu wandeln, die für eine Verwendung mit diesem Prozessor-Mittel (7) geeignet ist,
- Ausgangssignal-Schaltkreis-Mitteln (31, 32, 33; 35, 37, 39; 36, 38, 40), die dazu dienen, mehrere digitale Ausgangssignale $y_a(t)$ von dem Prozessor-Mittel (7) in analoge Form zu wandeln,
- mehrere Ausgangs-Geber (34, 41, 42), um Gegenvibrations-Phänomene zu erzeugen,

wobei das Prozessor-Mittel (7) an die Eingangssignal-Schaltkreis-Mittel und die Ausgangssignal-Schaltkreis-Mittel gekoppelt ist, um die mehreren Rest-Eingangssignale $e_s(t)$ zu erhalten und die mehreren Ausgangssignale $y_a(t)$ entsprechend einer Kombination dieser Rest-Signale zu erzeugen, wodurch die Vibrationsphänomene ausgelöscht werden,
**dadurch gekennzeichnet, daß**
das Prozessor-Mittel (7) ein Programm enthält, das auf einem Algorithmus beruht, in dem die gemeinsamen Wirkungen eines jeden der Geber-Signale $y_a(t)$ auf jedes der Rest-Signale $e_s(t)$ wegsubtrahiert werden, um geschätzte Sensor-Signale $x_s(t)$ von Sensoren ohne Gegen-Signale bereitzustellen und in dem geschätzte Sensor-Signale $x_s(t)$ mit anpaßbaren Auslöschungs-Filter-Koeffizienten $A_{s,a,m}(t)$ gefaltet werden, um die mehreren Ausgangs-Signale $y_a(t)$ zu bilden, wobei die anpaßbaren Filter-Koeffizienten entsprechend den Rest-Signalen und den geschätzten Sensor-Signalen aktualisiert werden.

**2.** System nach Anspruch 1, bei dem das Eingangssignal-Schaltkreis-Mittel Abtast- und Halte-Schaltkreis-Mittel (13, 26, 27) und ein Analog-Digital-Wandler-Mittel (14, 28, 29) enthält.

**3.** System nach Anspruch 1 oder 2, bei dem das Eingangssignal-Schaltkreis-Mittel eine Mehrzahl vorgesehener Eingangssignal-Schaltkreis-Mittel umfaßt, eines für jedes Eingangssignal.

**4.** System nach Anspruch 3, bei dem jedes vorgesehene Eingangssignal-Schaltkreis-Mittel Verstärker/Verstärkungs-Steuer-Endstufen (11, 22, 23), Anti-SignalverzerrungsFilter (12, 24, 25), Abtast- und Halte-Schaltkreise (13, 26, 27) und Analog-Digital-Wandler (14, 28, 29) enthält.

5. System nach Anspruch 1 bis 4, bei dem das Prozessor-Mittel (7) Mittel zum Anwenden eines mehrdimensionalen "filtered-x"-Algorithmus enthält, um die Auslöschungs-Filterkoeffizienten zu aktualisieren, um die gemeinsamen Wirkungen eines jeden der Geber-Signale von den Rest-Signalen zu subtrahieren, um bei jedem Sensor-Mittel ein geschätztes Eingangssignal bereitzustellen.

6. System nach Anspruch 1 bis 5, bei dem das Prozessor-Mittel (7) weiter Mittel enthält, um die abgeschätzten Eingangssignale $x_s(t)$ mit den Auslöschungs-Filter-Koeffizienten $A_{s,a,m}(t)$ zu falten, um Ausgangssignale zu erzeugen.

7. System nach Anspruch 1 bis 6, bei dem das Prozessor-Mittel (7) weiter Mittel zum fortlaufenden Aktualisieren der Auslöschungs-Filter-Koeffizienten $A_{s,a,m}(t)$ enthält.

8. System nach einem der vorstehenden Ansprüche, bei dem das Prozessor-Mittel (7) Mittel zum Aktualisieren von Auslöschungs-Filter-Koeffizienten $A_{s,a,m}(t)$ enthält, um bei jedem Sensor geschätzte Eingangssignale $x_s(t)$ bereitzustellen und die Signale mit den Koeffizienten zu falten, um Ausgangssignale zu erzeugen.

9. Verfahren zum Auslöschen von Geräusch, das die Schritte

   - des Detektierens von Vielfach-Restgeräusch-Erscheinungen $e_s(t)$,
   - des Umwandelns der Vielfach-Restgeräusch-Erscheinungen in digitale Form,
   - des Einspeisens der digitalen Restgeräusch-Erscheinungen in einen Prozessor,
   - des Berechnens von mehreren Ausgangssignalen in dem Prozessor,
   - des Ausgebens der Mehrfach-Ausgangssignale, um Gegen-Vibrations-Erscheinungen zu erzeugen, umfaßt,

   **dadurch gekennzeichnet, daß**
   es weiter die Schritte

   - des Wegsubtrahierens der überlagerten Wirkungen eines jeden der Geber-Signale $y_a(t)$ auf jedes der Rest-Signale $e_s(t)$, um geschätzte Sensorsignale $x_s(t)$ bereitzustellen,
   - des Faltens der geschätzten Sensor-Signale $x_s(t)$ mit anpaßbaren Auslöschungs-Filter-Koeffizienten $A_{s,a,m}(t)$, um die mehreren Ausgangssignale $y_a(t)$ zu bilden, aufweist,
wobei die anpaßbaren Auslöschungs-Filter-Koeffizienten entsprechend den Rest-Signalen und den geschätzten Sensor-Signalen fortlaufend aktualisiert werden, indem ein mehrdimensionaler "filtered-x"-Algorithmus angewandt wird.

10. Verfahren nach Anspruch 9, bei dem die mehreren Ausgangssignale und die geschätzten Sensor-Signale $x_s(t)$ durch Filter geführt werden, die ein Modell der Impulsantwort zwischen den jeweiligen Sensoren und Gebern sind.

## Revendications

1. Système d'annulation actif comprenant :

   - des moyens de capteurs multiples (1, 2, 3) destinés à détecter des phénomènes de vibration, chaque moyen de capteur produisant un signal résiduel approprié $e_s(t)$,
   - un moyen de processeur (7),
   - un moyen de circuits d'entrée (11, 12, 13, 14 ; 22, 24, 26, 28 ; 23, 25, 27, 29) relié aux moyens de capteurs multiples (1, 2, 3) et conçu pour convertir lesdits signaux résiduels sous une forme numérique adaptée à une utilisation par ledit moyen de processeur (7),
   - un moyen de circuits de sortie (31, 32, 33 ; 35, 37, 39 ; 36, 38, 40) conçu pour convertir des signaux de sortie numériques multiples $y_a(t)$ provenant dudit moyen de processeur (7) sous une forme analogique,
   - des actionneurs de sortie multiples (34, 41, 42) destinés à produire des phénomènes de contre-vibration,

   d'où il résulte que ledit moyen de processeur (7) est relié audit moyen de circuits d'entrée et audit moyen de circuits de sortie afin de recevoir les signaux d'entrée résiduels multiples $e_s(t)$ et de produire les signaux de sortie multiples $y_a(t)$ sur la base d'une combinaison desdits signaux résiduels, après quoi lesdits phénomènes de vibration sont annulés,
   caractérisé en ce que
   ledit moyen de processeur (7) contient un programme fondé sur un algorithme dans lequel les effets combinés de chacun des signaux d'actionneurs $y_a(t)$ sur chacun des signaux résiduels $e_s(t)$ sont soustraits afin de fournir des signaux de capteurs estimés $x_s(t)$ des capteurs sans contre-signaux et dans lequel les signaux de capteurs estimés $x_s(t)$ subissent une convolution avec des coefficients de filtres d'annulation adaptatifs $A_{s,a,m}(t)$ afin de former lesdits signaux de sortie multiples

$y_a(t)$, les coefficients de filtres adaptatifs étant mis à jour sur la base des signaux résiduels et des signaux de capteurs estimés.

**2.** Système selon la revendication 1, dans lequel ledit moyen de circuits d'entrée comprend un moyen de circuit échantillonneur-bloqueur (13, 26, 27) et un moyen de convertisseur analogique vers numérique (14, 28, 29).

**3.** Système selon la revendication 1 ou 2, dans lequel le moyen de circuits d'entrée comprend de multiples moyens de circuits d'entrée spécialisés, un pour chaque signal d'entrée.

**4.** Système selon la revendication 3, dans lequel chaque moyen de circuit d'entrée spécialisé comprend des étages d'amplificateur/commande de gain (11, 22, 23), des filtres antirepliement de spectre (12, 24, 25), des circuits échantillonneur-bloqueur (13, 26, 27) et des convertisseurs analogique vers numérique (14, 28, 29).

**5.** Système selon les revendications 1 à 4, dans lequel ledit moyen de processeur (7) comprend un moyen d'utilisation d'un algorithme à dimensions multiples filtré en x afin de mettre à jour les coefficients de filtres d'annulation en vue de soustraire les effets combinés de chacun des signaux d'actionneurs des signaux résiduels afin de fournir un signal d'entrée estimé à chaque moyen de capteur.

**6.** Système selon les revendications 1 à 5, dans lequel ledit moyen de processeur (7) comprend en outre un moyen destiné à appliquer une convolution auxdits signaux d'entrée estimés $x_s(t)$ avec des coefficients de filtres d'annulation $A_{s,a,m}(t)$ afin de produire des signaux de sortie.

**7.** Système selon les revendications 1 à 6, dans lequel ledit moyen de processeur (7) comprend en outre un moyen destiné à mettre à jour en permanence les coefficients de filtres d'annulation $A_{s,a,m}(t)$.

**8.** Système selon l'une des revendications précédentes, dans lequel ledit moyen de processeur (7) comprend un moyen destiné à mettre à jour les coefficients de filtres d'annulation $A_{s,a,m}(t)$ pour fournir des signaux d'entrée estimés $x_s(t)$ à chaque capteur et pour appliquer une convolution auxdits signaux avec lesdits coefficients afin de produire des signaux de sortie.

**9.** Procédé destiné à annuler un bruit comprenant les étapes consistant à :

- détecter des phénomènes de bruit résiduels multiples $e_s(t)$,

- convertir lesdits phénomènes de bruit résiduels multiples sous une forme numérique,

- appliquer lesdits phénomènes de bruit résiduels numérisés à un processeur,

- calculer des signaux de sortie multiples dans ledit processeur,

- fournir en sortie lesdits signaux de sortie multiples afin de générer des phénomènes de contre-vibration

caractérisé en ce que
il comprend en outre les étapes consistant à

- soustraire les effets combinés de chacun des signaux d'actionneurs $y_a(t)$ sur chacun des signaux résiduels $e_s(t)$ afin de fournir des signaux de capteurs estimés $x_s(t)$,

- appliquer une convolution auxdits signaux de capteurs estimés $x_s(t)$ avec des coefficients de filtres d'annulation adaptatifs $A_{s,a,m}(t)$ afin de former lesdits signaux de sortie multiples $y_a(t)$, d'où il résulte que les coefficients de filtres d'annulation adaptatifs sont en permanence mis à jour sur la base des signaux résiduels et des signaux de capteurs estimés en utilisant un algorithme à dimensions multiples filtré en x.

**10.** Procédé selon la revendication 9, dans lequel les signaux de sortie multiples et les signaux de capteurs estimés $x_s(t)$ sont transmis au travers de filtres qui constituent une modélisation de la réponse impulsionnelle entre les capteurs et les actionneurs respectifs.

FIG. 1

FIG. 2

EP 0 655 151 B1

FIG. 3A

S1  1
S2  2
Sn  3

8
9
10

5  INPUT MUX

11  AMPLIFIED GAIN CONTROL

12  ANTI-ALIASING FILTER

13  S & H

14  A/D

$r_1, r_2, r_n$

16,17,18

7  PROCESSOR

FIG. 3B

FIG. 4A

EP 0 655 151 B1

FIG. 4B

# FIG.5A

**FIG.5**

| FIG.5A |
|--------|
| FIG.5B |

EP 0 655 151 B1

EP 0 655 151 B1

$y_1$   $y_2$   $y_n$

DELAY LINE   DELAY LINE   DELAY LINE

45   48   51

$C_{1,n}$   $C_{2,n}$   $C_{n,n}$

3   18

$S_n$   $r_n$   $\Sigma$   $x_n$   DELAY LINE   57

54

B   A   $\Sigma$   19   $y_1$

$A_{n,1}$   66

$C_{1,n}$   DELAY LINE   ADAPTER

45   60   63

FIG. 5B